# EUROPÄISCHE PATENTSCHRIFT

(11) **EP 1 017 262 B1**
(45) Veröffentlichungstag und Bekanntmachung des Hinweises auf die Patenterteilung: **22.09.2004**
(21) Anmeldenummer: 99811150.4
(22) Anmeldetag: 13.12.1999
(51) Int. Cl.: H05K 7/14

(54) **Steckbaugruppe mit Aktiv-Passiv-Schaltung**
Plug-in unit with active/passive switching
Unitè enfichable avec dispositif d' activation et de déactivation

(30) Priorität: 28.12.1998 DE 29823122 U; 17.03.1999 EP 99810234
(43) Veröffentlichungstag der Anmeldung: 05.07.2000
(60) Teilanmeldung: 04013307.6
(73) Patentinhaber: ELMA Electronic AG, 8620 Wetzikon (CH)
(72) Erfinder: Ulrich, Daniele, 8624 Grüt (CH)
(74) Vertreter: Sulzer Management AG

(56) Entgegenhaltungen:
- EP-A- 0 699 019
- WO-A-96/42187
- WO-A-98/34449
- "LATCHES FOR EQUIPMENT DRAWERS" NTIS TECH NOTES,US,US DEPARTMENT OF COMMERCE. SPRINGFIELD, VA, 1. September 1992 (1992-09-01), Seite 671 XP000322552 ISSN: 0889-8464

## Beschreibung

Die Erfindung handelt von einem Baugruppenträger mit einer Steckbaugruppe, welche mittels Führungen in einem Gehäuse einführbar ist und welche mit mindestens einem Ein- und Aushebegriff in Form eines auf einer Achse gelagerten Hebels an ihrer Frontseite versehen ist, um durch Abstützen an einem frontseitigen Gehäuseprofil Einstoss- und Ausziehkräfte an rückseitig angebrachten Mehrfachsteckern zu überwinden.

In der WO 96/42187 wird ein Frontsystem für eine Flachbaugruppe mit Aktiv-Passiv-Schaltung gezeigt, welches unabhängig davon, ob eine Verriegelung wirklich eingetreten ist, eine Einfahrstellung der Flachbaugruppe über ein Schaltelement abtastet. Ein unabsichtliches nicht Einrasten einer Verriegelung sowie ein Verschieben des Schaltpunktes in Einschubrichtung können zu Schaltzuständen führen, die im Widerspruch zur mechanischen Situation stehen.

Aufgabe der Erfindung ist es, eine sichere Verriegelung für Baugruppenträger mit Steckbaugruppen zu schaffen. Diese Aufgabe wird dadurch gelöst, dass für den Ein- und Aushebegriff ein zusätzlicher federbetätigter Riegel an der Frontseite angebracht ist, welcher den Hebel zwangsläufig in einer hinteren Endstellung der Steckbaugruppe verriegelt und welcher nach der Entriegelung des Hebels eine Verriegelung des Hebels nur möglich macht, wenn der Hebel mindestens um einen Winkel α ≥ ε in Ausfahrrichtung und wieder zurück in die hintere Endstellung gedreht ist, wobei der Winkel ε eine Überlappung darstellt, mit der der Riegel sich in der Entriegelstellung an einer Führungsfläche des Hebels selbst blockiert, während beim Drehen des Hebels um einen Winkel α ≥ ε und zurück der Riegel durch die Führungsfläche in einer weiteren Entriegelstellung gehalten ist.

Diese Anordnung hat den Vorteil, dass sie die Wirksamkeit der Verriegelung des Ein- und Aushebegriffs überwacht.

Ein weiterer Vorteil besteht darin, dass die räumliche Anordnung von Hebel und Riegel so geschickt vorgenommen ist, dass die räumlichen und schalttechnischen Anforderungen der Normen
- IEEE STANDARD 1101.10
- HOT SWAP SPECIFICATION PICMG 2.1 R1.0
- VME 64 EXTENSIONS STANDARD VITA 1.1-199X, DRAFT 2.0
erfüllbar sind.

Weitere vorteilhafte Ausführungen der Erfindung ergeben sich aus den Merkmalen der abhängigen Ansprüche 2 bis 14. So besteht ein Vorteil, dadurch, dass der Riegel nach dem Erreichen einer wirksamen Verriegelstellung ein Schaltelement für eine Aktivschaltung der Steckbaugruppe betätigt, sowie dass bei einem Niederdrücken des Riegels dieser am Schaltelement eine Passiv-Schaltung bewirkt bevor der Hebel durch den Riegel freigegeben ist.

Damit wird das Schaltelement für die Aktiv-Schaltung erst dann betätigt, wenn eine Verriegelung des Griffhebels stattgefunden hat, und das elektrisch wirkende Schaltelement ist bereits passiv geschaltet, wenn die Verriegelung den Griffhebel freigibt. Ein weiterer Vorteil besteht bei einem unabsichtlichen Niederdrücken der Verriegelung, da zum einen eine Passiv-Schaltung bereits stattgefunden haben muss, wenn sich der Riegel in der entriegelten Stellung hält, und zum anderen eine Mindestdrehung vorwärts und rückwärts des Griffhebels erfolgen muss, bevor überhaupt wieder eine Verriegelung mit anschliessender Aktivierung des Schaltelements erfolgen kann.

Beim Niederdrücken des Riegels blockiert sich dieser aus der verriegelten Stellung in einer entriegelten Stellung ohne aktives Einwirken anderer Elemente und mit der Drehung des Hebels blockiert dieser den Riegel solange in einer Entriegelstellung bis er mit der Steckbaugruppe die hintere Endstellung wieder erreicht hat. Die eigentliche Verriegelung findet zwangsweise durch eine Feder mit dem Erreichen der hinteren Endstellung statt. Dies hat den Vorteil, dass die Betätigung des Schaltelements immer durch die gleich vorgespannte Feder erfolgt und von der Geschwindigkeit und den Stössen beim Einfahren der Steckbaugruppe unbeeinflusst ist. Dadurch, dass der Riegel unabhängig vom Hebel in einer geraden Führung an der Frontseite der Steckbaugruppe geführt ist, muss der Hebel nicht bewegt werden, um in eine Entriegelstellung zu kommen. Der Hebel kann erst mit Drehen in Ausstossrichtung anfangen wenn ein Anschlag am Riegel, der entgegen der Drehrichtung des Hebels angeordnet ist, ausgefahren ist.

Ein Schlag auf den verriegelten Hebel verursacht auch kein Prellen am Schaltelement, da der Riegel unabhängig vom Hebel in der Schaltrichtung des Schaltelements abgestützt ist.

Die Vorteile der mechanischen Verriegelung lassen sich auch ohne elektrisches Schaltelement ausnutzen. So kann ein zweiter gespiegelter Hebel mit Verriegelung am anderen Ende der Frontseite einer Steckbaugruppe angebracht sein, um das Ein- und Aushebeln zu erleichtern und um lediglich eine weitere Verriegelung der Steckbaugruppe im eingefahrenen Zustand zu erreichen. Bei einer solchen Anordnung kann auf eine zusätzliche Verschraubung zwischen Frontplatte und Gehäuseprofil verzichtet werden, sodass am Gehäuseprofil nur vorlaufende Zentrierstifte eingreifen, um Seitenkräfte aufzunehmen.

Dadurch, dass sich mit dem Erreichen der Entriegelstellung ein Überlappungswinkel ε zwischen dem Hebel und dem Riegel einstellt, um den der Hebel mindestens gedreht werden muss bevor wieder eine Verriegelt-Stellung durch Zurückdrehen des Hebels erreicht werden kann, ist es vorteilhaft, wenn der Winkel ϕ für den Flankenwechsel zum Ausstossen grösser als der Überlappungswinkel ε ist. Dies bewirkt, dass die Umkehr vom entriegelten Zustand zum verriegelten Zustand möglich ist, ohne dass eine Bewegung an den rückseitig angebrachten Mehrfachsteckern der Steckbaugruppe stattfindet.

Hebel und Riegel sind so konstruiert, dass sie jeweils im Spritzverfahren in einem Spritzwerkzeug herstellbar sind, wobei die wesentlichen Funktionsmasse für den gegenseitigen Eingriff werkzeuggebundene Masse sind. Entsprechend klein sind die Herstelltoleranzen, was eine grosse Sicherheit für die Funktion bewirkt.

Im folgenden wird die Erfindung anhand von Ausführungsbeispielen beschrieben. Es zeigen:
- Fig. 1: Schematisch einen Ausschnitt an der unteren Frontseite einer Steckbaugruppe beim Ausstossen aus dem Gehäuse eines Baugruppenträgers;
- Fig. 2: schematisch einen Schnitt durch eine Anordnung in ausgefahrener Stellung gemäss Fig. 1;
- Fig. 3: schematisch die Anordnung von Fig. 2 in eingefahrener Stellung verriegelt;
- Fig. 4: schematisch die Anordnung von Fig. 3 in eingefahrener Stellung entriegelt;
- Fig. 5: schematisch eine Ansicht einer weiteren Ausführung eines Einund Aushebegriffs, dessen Hebelarm in der hinteren Endstellung der Steckbaugruppe parallel zur Frontplatte ausgerichtet ist und ein Fenster aufweist, durch welches Anzeigeelemente in der Frontplatte sichtbar sind; und
- Fig. 6: schematisch eine Seitenansicht der Ausführung von Fig. 5.

In den Figuren ist ein Baugruppenträger mit einer Steckbaugruppe 2 gezeigt, welche mit einem Ein- und Aushebegriff 5 in eine und aus einer hinteren Endstellung 10 beweglich ist. Ein zusätzlicher federbetätigter Riegel 12 an der Frontseite 7, welcher den Ein- und Aushebegriff zwangsläufig in der hinteren Endstellung sichert, betätigt nach dem Erreichen einer wirksamen Verriegelstellung ein Schaltelement 11 für eine Aktiv-Schaltung der Steckbaugruppe. Ein Niederdrücken des Riegels 12 bewirkt im verriegelten Zustand eine Passiv-Schaltung, bevor der Ein- und Aushebegriff 5 nach einem weiteren Stück Verschiebeweg des Riegels entriegelt ist und die Entriegelung im Zusammenwirken mit Riegel 12 mechanisch speichert.

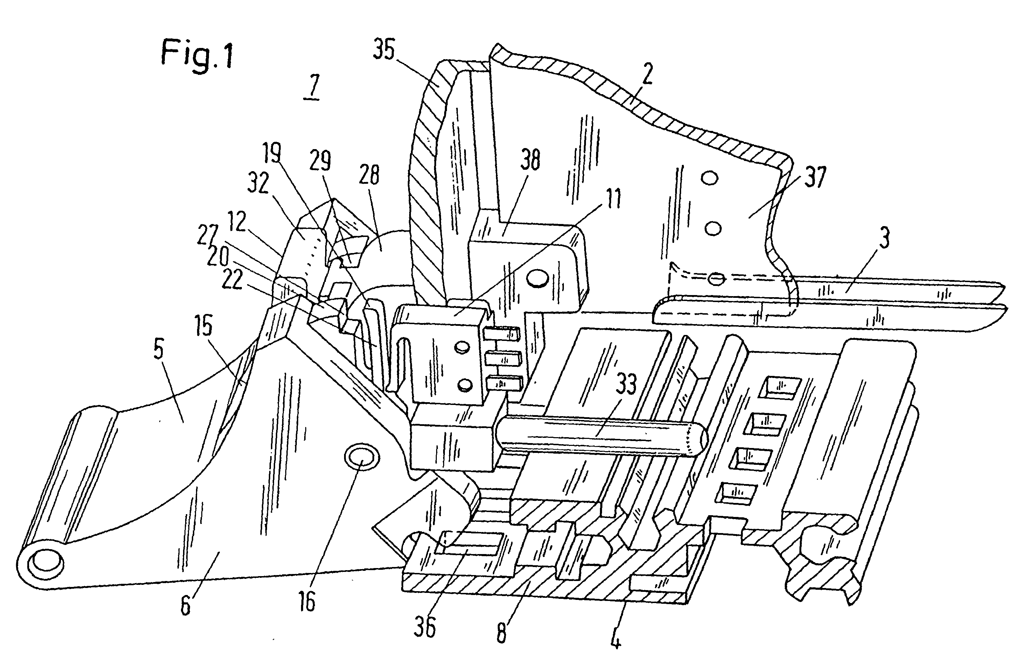

In Fig. 1 ist die Steckbaugruppe 2 an ihrer Frontseite 7 als Printplatte 2 über Befestigungselemente 38 mit einer Frontplatte 35 zusammengesetzt. An der Frontplatte 35 ist ebenfalls am unteren und oberen Ende ein Sockel 28 befestigt, der einen Tragkörper für das Schaltelement 11 sowie für den Hebel 6 über eine Achse 16 bildet. Vor der Achse 16 und parallel zur Frontplatte 35 ist der Sockel 28 zu einem T-förmigen Profil ausgebildet, welches mit seinen Nuten 29 eine vertikale Längsführung für den Riegel 12 bildet, der das T-förmige Profil umgreift. Der Ein- und Aushebegriff 5 ist als Hebel 6 ausgebildet, der mit zwei seitlichen Laschen über die Achse 16 am Sockel 28 drehbar gelagert ist und den Riegel 12 mitsamt dem Sockel weitgehend abdeckt. Am Ein- und Aushebegriff 5 ist eine Ausnehmung 15, durch welche der Riegel 12 mit einem Vorsprung 32 für seine Betätigung herausragt. Am Riegel 12 sind in einer Ebene senkrecht zur Achse 16 funktionale Elemente wie eine Eingriffsfläche 20, ein Anschlag 27 und ein seitlich angeformtes Federelement mit einer Eingriffsfläche 19 gezeigt, die im Zusammenwirken mit dem Hebel 6 das Schaltelement 11 betätigen. Die Steckbaugruppe ist an ihrer Unter- und Oberseite in Führungen 3 am Gehäuse 4 einschiebbar, um auf ihrer Rückseite (hier nicht gezeigt) eine Verbindung über Mehrfachstecker herzustellen. Am Sockel 28 ist ein voreilender Kontaktstift 33 befestigt, um eine Erdung der Steckbaugruppe vor dem Betätigen der Mehrfachstecker zu erreichen. Das Schaltelement 11 ist als Mikroschalter mit Steckkontakten ausgeführt, um es an die Printplatte 37 anschliessen zu können. Das Gehäuse endet zur Frontseite 7 hin als Gehäuseprofil 8 mit Ausnehmungen 36, in welche der Hebel 6 eingreifen kann, um beim Einstossen durch seine Untersetzung die Klemmkräfte an den rückseitigen Mehrfachsteckern leichter zu überwinden.

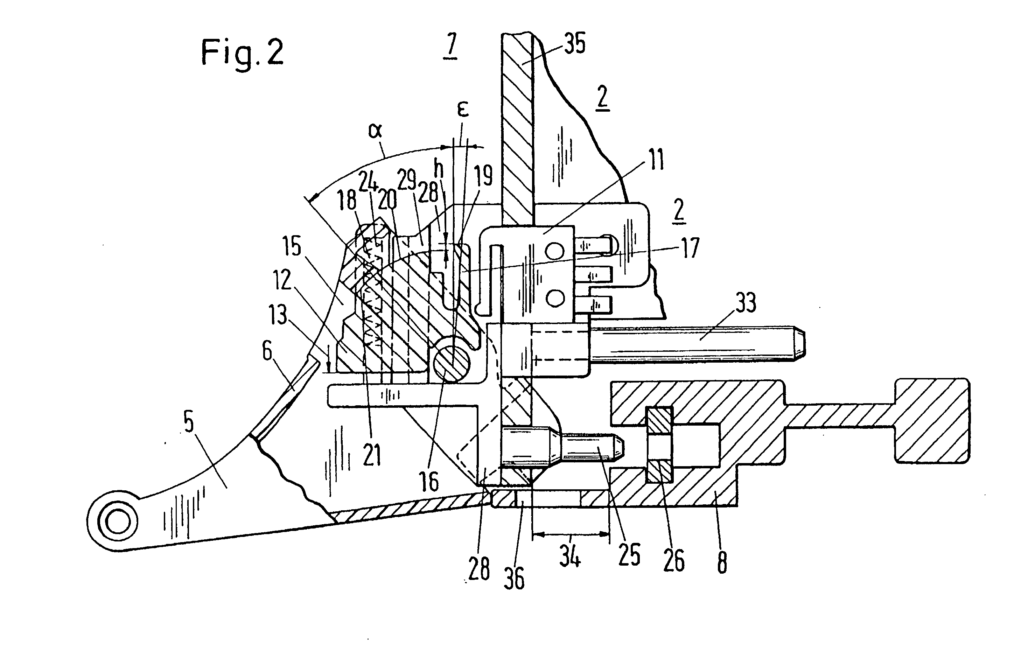

Die weiteren Figuren 2 bis 4 sind mit gleichen Hinweiszeichen versehen und stellen verschiedene Schaltsituationen dar, wobei Riegel 12 und Hebel 6 in der vorher erwähnten Ebene für die funktionalen Elemente geschnitten sind. Die Fig. 2 stellt beim Ausheben der Steckbaugruppe die Stellung dar, in der die Drehung des Hebels 6 um einen Winkel α ein Ausheben um einen Aushebeweg 34 mit einem Betrag von beispielsweise 6,5 mm bewirkt hat, und zur Fortsetzung der Bewegung die Steckbaugruppe an den Hebeln 6 ohne Drehung herausgezogen wird.

In der gleichen Drehwinkelstellung a muss die Steckbaugruppe eingeschoben werden, damit die vorstehenden Nasen vom Hebel 6 in die Ausnehmungen 36 am Gehäuseprofil 8 eintauchen können. In dieser Situation wird der Riegel 12 durch eine Rückstellfeder 24 längs der Führungsnuten 29 nach oben gepresst und liegt mit der kreisförmigen Eingriffsfläche 20 an einer ebenfalls kreisförmigen Führungsfläche 21 des Hebels mit Radius 31 an. Die vertikale Position des Riegels 12 entspricht einer Entriegelstellung 13, die bei einer Drehung des Hebels unverändert bleibt, da beide Kreisflächen 20, 21 in ihrem Zentrum mit dem der Achse 12 zusammenfallen. Bei einem Zurückdrehen des Hebels 6 um den Winkel α wird eine Schrägschulter 18 mit einer Überlappung einer Höhe h, die beispielsweise 1 mm betragen kann, bis zur Berührung an eine Blattfeder 17 herangeführt. In dieser Stellung überdeckt die Führungsfläche 21 immer noch Teile der Eingriffsfläche 20 und verhindert, dass der Riegel 12 von der Rückstellfeder 18 nach oben gestossen wird.

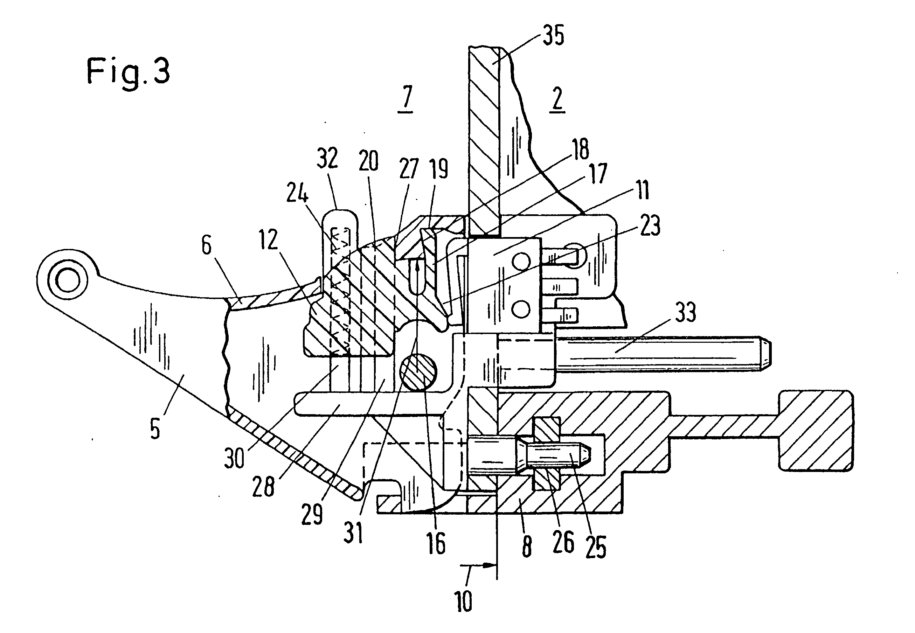

Erst nach dem Weiterdrehen um einen Winkelbetrag ε wird der Riegel 12 freigegeben und gleichzeitig die Blattfeder 17 um diesen Betrag zurückgebogen. Die Rückstellfeder 24 ist so ausgelegt, dass sie die Reibung vom Riegel 12 am Sockel 28 und am Hebel 6 sowie die Schaltkraft von einem Nocken 23 gegen Schaltelement 11 mit Sicherheit überwindet, um in die Stellung entsprechend Fig. 3 zu gelangen. Ein Anschlag 27 am Riegel 12 verhindert, dass sich der Hebel 6 trotz vorgespannter Blattfeder zurückdreht.

Der mit der Rückstellfeder ausgelöste Bewegungsablauf sieht zunächst vor, dass der Hebel 6 verriegelt ist, dass anschliessend in einem Sicherheitsabstand der Nocken 23 das Schaltelement betätigt und dass mit dem vollständigen Einfahren des Riegels 12 die Spitze der Blattfeder 17 an der Schrägfläche 18 des Hebels um einen Winkelbetrag ε in ihre entspannte Stellung zurückgleiten kann. Diese in Fig. 3 eingenommene Lage wird zwangsläufig durch die Drehung des Hebels 6 erreicht und entspricht dem Endzustand beim Einfahren der Steckbaugruppe.

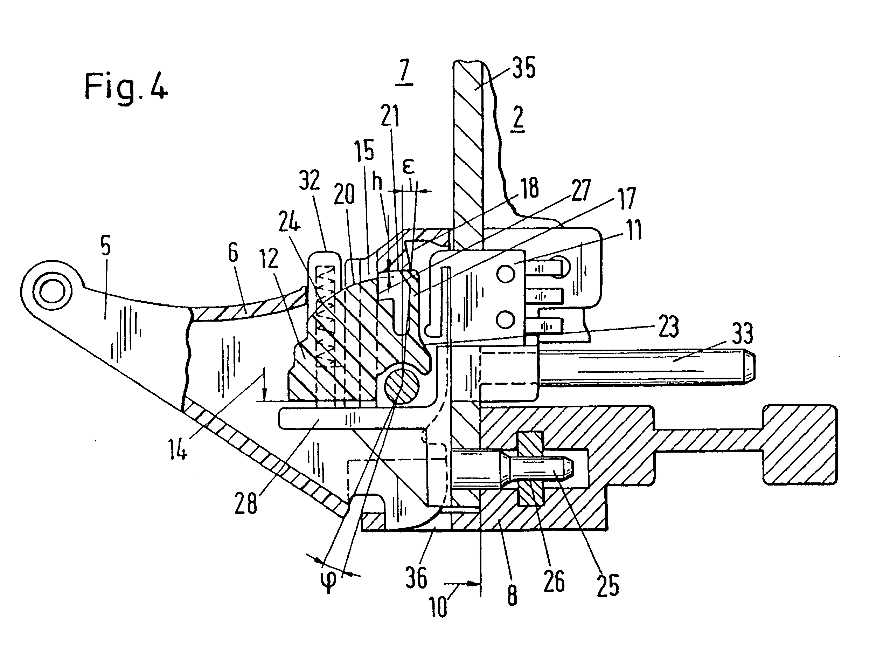

Aus diesem verriegelten Endzustand findet das Ausheben der Steckbaugruppe statt, indem zunächst der Riegel 12 am Vorsprung 32 niedergedrückt wird. Dabei verlässt der abwärtsfahrende Nocken 23 den Mikroschalter und löst das Passiv-Schalten der Steckbaugruppe aus, während eine Drehbewegung des Hebels 6 immer noch durch den Anschlag 27 am Riegel gesperrt ist. Während dem Abwärtsfahren des Riegels 12 wird die Blattfeder um einen Winkelbetrag ε auf der Schrägfläche 18 des Hebels vorgespannt, um den sie zurückfedert sobald ihre Spitze von der Schrägfläche 18 freigegeben ist. Durch das Zurückfedern stellt sich eine Überlappung zwischen einer Eingriffsfläche 19 und der Führungsfläche 21 ein und es entsteht der entriegelte Zustand von Fig. 4, aus dem heraus der Hebel 6 gedreht werden kann und in dem Mass wie die Überlappung zwischen Eingriffsfläche 19 und Führungsfläche 21 abnimmt eine neue Überlappung zwischen Führungsfläche 21 und Eingriffsfläche 20 aufbaut. Sobald die Eingriffsfläche 19 der Blattfeder verlassen ist, wird der Riegel aus einer Entriegelstellung 14 um das Höhenmass "h" in die Entriegelstellung 13 gestossen, in der sich die kreisförmige Eingriffsfläche 20 und die Führungsfläche 21 berühren. Je weiter die Führungsfläche 21 mit der Drehung des Hebels 6 auf der Eingriffsfläche 20 hinunterrutscht desto grösser ist bei konstanter Federkraft die Normalkraft zwischen diesen beiden Flächen und damit auch die Reibungskraft, sodass der Hebel 6 mit dem Erreichen eines Winkels a wie in Fig. 2 in dieser Winkelstellung durch die grösste Reibungskraft gehalten ist. Dies hat den Vorteil, dass der Hebel 6 auch in einer gespiegelten Anordnung an der oberen Frontseite trotz seines Eigengewichtes nicht herunterfällt sondern in der durch den Winkel α vorgegebenen Position, die durch das Anschlagen des Hebels 6 am Sockel 28 bestimmt ist, beibehalten werden kann.

Ein weiterer Vorteil besteht darin, dass die Aktiv- oder Passiv-Schaltung der Steckbaugruppe auch äusserlich durch die Verriegelt- oder Entriegelt-Position des Riegels sichtbar ist.

Es versteht sich, dass die hier gezeigte Mechanik der Verriegelung die äusserlich durch die Position des Vorsprungs 32 angezeigt ist auch ohne Schaltelement 11 und allgemein ausserhalb der zitierten Normen für eine visuell oder taktil kontrollierbare Verriegelung verwenden lässt.

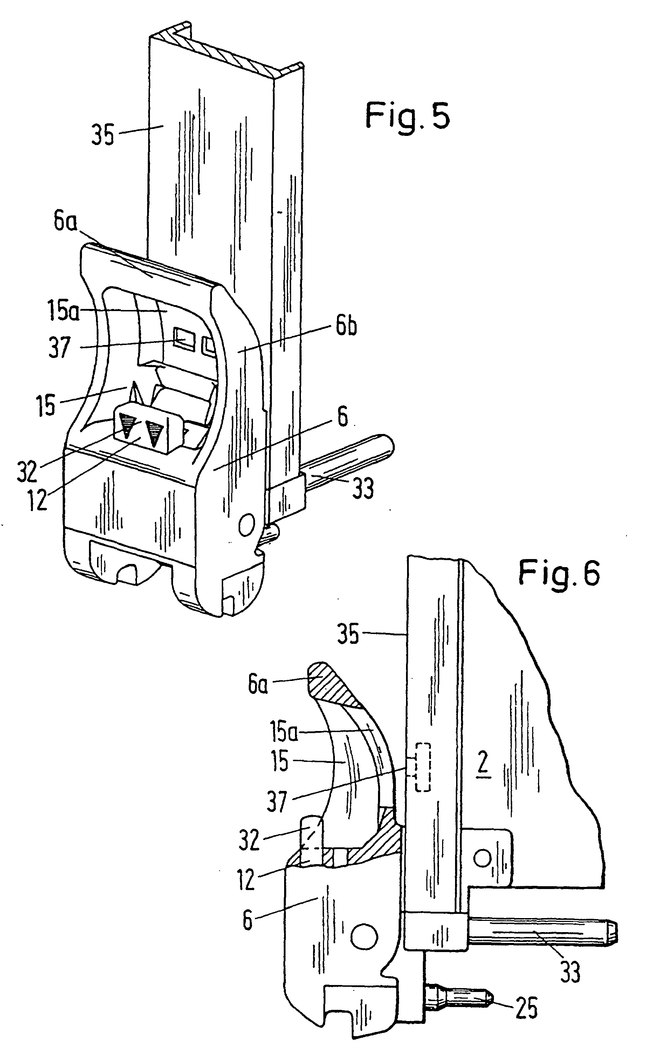

In einer weiteren Ausführung Fig. 5 und Fig. 6 ist der Hebelarm 6 des Einund Aushebegriffs 5 so gestaltet, dass der Hebelarm 6 mit dem Erreichen der hinteren Endstellung der Steckbaugruppe parallel zur Frontplatte 35 ausgerichtet ist. Eine Ausnehmung 15, in welche der Riegel 12 mit seinem Vorsprung 32 für seine Betätigung hineinragt, ist in dieser Stellung auf der Vorderseite angebracht. Die Ausnehmung 15 ist so gross bemessen, dass der Vorsprung 32 mit mindestens einer Fingerkuppe zum Entriegeln niedergedrückt werden kann. Diese Anordnung hat den Vorteil, dass der Hebelarm 6 nicht weit vorsteht und dass der Riegel 12 durch den schalenförmig darüberstehenden Hebelarm 6 mechanisch geschützt ist.

Ein weiterer Vorteil, der ganz allgemein für parallel zur Frontplatte ausgerichtete Ein- und Aushebegriffe gilt, besteht darin, dass das ein solcher Hebelarm 6, der zwangsläufig einen Teil der Frontplatte 35 abdeckt, mit einem Fenster 15a versehen wird oder aus einem transparentem Material gefertigt ist, um dahinterliegende Anzeigeelemente 37 in der Frontplatte 35 sichtbar zu machen.

Im vorliegenden Ausführungsbeispiel von Fig. 5 und 6 ist im Hebelarm 6 ein Fenster 15a angebracht, sodass der Hebelarm 6 eigentlich zwei Seitenwangen 6b und eine Traverse 6a aufweist. Durch das Fenster 15a sind Leuchtdioden als Anzeigeelemente 37 auf der Frontplatte 35 sichtbar, die über den Status der Steckbaugruppe 2 Auskunft geben können. Wenn ein solcher Hebelarm 6 mit einem Verriegelungsmechanismus, wie er in dem Beispiel der Figuren 1 bis 4 beschrieben ist, kombiniert wird, dann hat dies auch noch den Vorteil, dass durch das Fenster 15a ein zusätzliches optisches Signal für das unbeschadete Ausfahren der Steckbaugruppe sichtbar gemacht werden kann. Der Ablauf würde dann so ergänzt, dass durch das Niederdrücken des Riegels 12 die Passiv-Schaltung eingeleitet wird und der Hebel zum Aushebeln der Steckbaugruppe freigegeben wird und dass mit dem Erreichen der Passiv-Schaltung ein entsprechendes Signal durch das Fenster sichtbar wird, welches dem Bedienungspersonal signalisiert, wann die Passiv-Schaltung abgeschlossen ist. Dies ist dann von Vorteil, wenn die Passiv-Schaltung längere Zeit beansprucht, weil beispielsweise bestimmte Schaltzustände in der Steckbaugruppe 2 nicht sofort erreicht werden können. Eine weitere Hilfestellung für diesen Fall liegt in der Gestaltung der Abmessungen des Hebelarms 6. Die Aussparung 15 ist so gewählt, dass sie mit mindestens einem Finger die Betätigung vom Riegel 12 gestattet, während auf der Traverse vom Hebel 6 zwei und mehr Finger Platz finden. Eine Bedienungsperson muss mit mindestens einem Finger den Riegel 12 betätigen und kann während dieser Zeit höchstens einen benachbarten Finger auf der Traverse 6a in einer eher unangenehmen Haltung oder eben gar nicht absetzen. Sobald sie nun in einer Folgebewegung den Entriegelungsfinger und eventuelle weitere auf die Traverse setzt, um die nicht geringen Kontaktkräfte beim Aushebeln zu überwinden, wird das Fenster 15a freigegeben und die Statusanzeige der Passiv-Schaltung sichtbar. Es besteht also allgemein und speziell im Fall einer verzögerten Passiv-Schaltung die Möglichkeit einer Kontrolle vom Status der Steckbaugruppe 2 an dem Ort, an dem die Betätigung für die Trennung für die rückseitigen Kontakte vorgenommen werden soll. Eine weitere Möglichkeit besteht darin, die Aussparung 15 und das Fenster 15a so hoch zu machen, dass die Anzeige 37 über den Entriegelungsfinger weg sichtbar ist.

## Patentansprüche

1. Baugruppenträger mit einer Steckbaugruppe (2), welche mittels Führungen (3) in einem Gehäuse (4) einführbar ist und welche mit mindestens einem Ein- und Aushebegriff (5) in Form eines auf einer Achse (16) gelagerten Hebels (6) an ihrer Frontseite (7) versehen ist, um durch Abstützen an einem frontseitigen Gehäuseprofil (8) Einstoss- und Ausziehkräfte an rückseitig angebrachten Mehrfachsteckern zu überwinden, **dadurch gekennzeichnet, dass** für den Ein- und Aushebegriff (5) ein zusätzlicher federbetätigter Riegel (12) an der Frontseite (7) angebracht ist, welcher den Hebel zwangsläufig in einer hinteren Endstellung (10) der Steckbaugruppe verriegelt und welcher nach der Entriegelung des Hebels (6) eine Verriegelung des Hebels nur möglich macht, wenn der Hebel (6) mindestens um einen Winkel α ≥ ε in Ausfahrrichtung und wieder zurück in die hintere Endstellung (10) gedreht ist, wobei der Winkel ε eine Überlappung darstellt, mit der der Riegel (12) sich in der Entriegelstellung (14) an einer Führungsfläche (21) des Hebels (6) selbst blockiert, während beim Drehen des Hebels (6) um einen Winkel α ≥ ε und zurück der Riegel (12) durch die Führungsfläche (21) in einer weiteren Entriegelstellung (13) gehalten ist.

2. Baugruppenträger mit einer Steckbaugruppe nach Anspruch 1, **dadurch gekennzeichnet, dass** die Entriegelung primär durch ein am Riegel (12) befestigtes Federelement (22) gespeichert ist, welches beim Niederdrücken des Riegels (12) an einer Schrägschulter (18) des Hebels (6) um den Winkel ε entgegen der Ausstossrichtung des Hebels auslenkbar ist, um nach dem Verlassen der Schrägschulter (18) in eine Stellung mit einer Überlappung in der Grösse des Winkels ε zurückzufedern.

3. Baugruppenträger mit einer Steckbaugruppe nach Anspruch 2, **dadurch gekennzeichnet, dass** als Federelement (22) eine Blattfeder (17) vorgesehen ist und dass Blattfeder (17) und Riegel (12) Eingriffsflächen (19, 20) aufweisen, die an einer um die Achse (16) schwenkbaren Führungsfläche (21) des Hebels (6) anlegbar sind, wobei die Eingriffsfläche (19) des Federelements (22) um eine Höhe h weiter von der Achse (16) als die Eingriffsfläche (20) des Riegels (12) entfernt ist.

4. Baugruppenträger mit einer Steckbaugruppe nach einem der Ansprüche 1 bis 3, **dadurch gekennzeichnet, dass** der Riegel (12) entgegen seiner Niederdrückrichtung mit einer ortsfest abgestützten Rückstellfeder (24) versehen ist.

5. Baugruppenträger mit einer Steckbaugruppe nach einem der Ansprüche 1 bis 4, **dadurch gekennzeichnet, dass** die Steckbaugruppe (2) einen weiteren, mechanisch gleichen Verriegelungsmechanismus aufweist, um auf zusätzliche mechanische Sicherungselemente wie zum Beispiel Befestigungsschrauben verzichten zu können.

6. Baugruppenträger mit einer Steckbaugruppe nach Anspruch 5, **dadurch gekennzeichnet, dass** an der Frontseite der Steckbaugruppe in Einschubrichtung vorstehende Zentrierstifte (25) angebracht sind, welche die Steckbaugruppe (2) frontseitig in passenden Bohrungen (26) am frontseitigen Gehäuseprofil (8) ausrichten.

7. Baugruppenträger mit einer Steckbaugruppe nach einem der Ansprüche 1 bis 6, **dadurch gekennzeichnet, dass** der Überlappungswinkel ε kleiner ist als Winkel ϕ für den Flankenwechsel am Griffhebel (6) zwischen Ende des Einstossens in die hintere Endstellung (10) und dem Beginn des Ausstossens der Steckbaugruppe (2) in umgekehrter Richtung.

8. Baugruppenträger mit einer Steckbaugruppe nach einem der Ansprüche 1 bis 7, **dadurch gekennzeichnet, dass** Hebel (6) und Riegel (12) jeweils in einer Spritzform hergestellt sind, um die Streuung der Funktionsmasse für Verriegelung und Entriegelung klein zu halten.

9. Baugruppenträger mit einer Steckbaugruppe nach einem der Ansprüche 1 bis 8, **dadurch gekennzeichnet, dass** der für den Hebel (6) und den Riegel (12) beanspruchte Platzbedarf innerhalb der für den Ein- und Aushebegriff (5) zugestandenen Abmessungen des IEEE STANDARDS 1101.10 liegt.

10. Baugruppenträger mit einer Steckbaugruppe nach einem der Ansprüche 1 bis 9, **dadurch gekennzeichnet, dass** der Hebelarm (6) in der hinteren Endstellung (10) der Steckbaugruppe (2) parallel zur Frontplatte (35) der Steckbaugruppe ausgerichtet ist, um im Normalbetrieb möglichst wenig von der Frontplatte wegzustehen.

11. Baugruppenträger mit einer Steckbaugruppe nach einem der Ansprüche 1 bis 10, **dadurch gekennzeichnet, dass** der Riegel (12) nach dem Erreichen einer wirksamen Verriegelstellung ein Schaltelement (11) für eine Aktivschaltung der Steckbaugruppe (2) betätigt, sowie dass bei einem Niederdrücken des Riegels (12) dieser am Schaltelement (11) eine Passiv-Schaltung bewirkt bevor der Hebel (6) durch den Riegel freigegeben ist.

12. Baugruppenträger mit einer Steckbaugruppe nach Anspruch 11, **dadurch gekennzeichnet, dass** der Riegel (12) einen Nocken (23) zum Betätigen des Schaltelements (11) aufweist, der quer zur Schaltrichtung des Schaltelements (11) verschiebbar ist.

13. Baugruppenträger mit einer Steckbaugruppe nach einem der Ansprüche 11 oder 12, **dadurch gekennzeichnet, dass** das elektrische Schaltelement (11) ein elektrischer Mikroschalter ist.

14. Baugruppenträger mit einer Steckbaugruppe nach einem der Ansprüche 11 bis 13, **dadurch gekennzeichnet, dass** hinter dem verriegelten Hebel (6) eine Statusanzeige (37) für die Passiv-Schaltung der Steckbaugruppe angebracht ist, und dass der Hebel ein Fenster (15a) aufweist oder transparent ist, damit die Statusanzeige (37) von vorne ablesbar ist.

## Claims

1. Module carrier comprising a plug module (2) which can be inserted by means of guides (3) in a housing (4) and which is provided with at least one insertion and removal handle (5) in the form of a lever (6) journalled on an axle (16) at its front side (7) in order, through support at a front-side housing section (8), to overcome push-in and draw-out forces at multiple plugs which are attached at the rear side, **characterised in that** an additional spring-actuated bolt (12) for the insertion and removal handle (5) is attached to the front side (7) which compulsorily locks the lever in a rear end position (10) of the plug module and which, after unlocking of the lever (6) enables a latching of the lever only when the lever (6) has been turned by at least an angle α ≥ ε in the moving-out direction and back again into the rear end position (10), with the angle ε representing an overlap by means of which the bolt (12) blocks itself in the unlocked position (14) at a guide surface (21) of the lever (6) whereas, when the lever (6) is rotated by an angle α ≥ ε and back, the bolt (12) is held by the guide surface (21) in a further unlocked position (13).

2. Module carrier comprising a plug module in accordance with claim 1, **characterised in that** the unlocking is primarily stored by a spring element (22) which is secured to the bolt (12) and which, when the bolt (12) is pressed down at an inclined shoulder (18) of the lever (6), is deflectable by the angle ε opposite to the ejection direction of the lever in order to move resiliently back into a position with an overlap of the magnitude of the angle ε after leaving the inclined shoulder (18).

3. Module carrier comprising a plug module in accordance with claim 2, **characterised in that** a leaf spring (17) is provided as the spring element (22); and **in that** the leaf spring (17) and the bolt (12) have engagement surfaces (19, 20) which can be brought into contact at a guide surface (21) of the lever (6) pivotable about the axle (16), with the engagement surface (19) of the spring element (22) being further distant from the axle (16) by a height h than the engagement surface (20) of the bolt (12).

4. Module carrier comprising a plug module in accordance with any one of the claims 1 to 3, **characterised in that** the bolt (12) is provided with a resetting spring (24) supported at a fixed position opposing the direction of depression of the bolt.

5. Module carrier comprising a plug module in accordance with any one of the claims 1 to 4, **characterised in that** the plug module (2) has a further, mechanically the same, locking mechanism in order to be able to dispense with additional mechanical securing elements such as for example securing screws.

6. Module carrier comprising a plug module in accordance with claim 5, **characterised in that** centering pins (25) which project in the push-in direction are provided at the front side of the plug module which align the plug module (2) at the front side in matching bores (26) at the front-side housing section (8).

7. Module carrier comprising a plug module in accordance with any one of the claims 1 to 6, **characterised in that** the overlap angle ε is smaller than the angle ϕ for the flank change at the handle lever (6) between the end of inward pushing into the rear end position (10) and the start of the ejection of the plug module (2) in the opposite direction.

8. Module carrier comprising a plug module in accordance with any one of the claims 1 to 7, **characterised in that** the lever (6) and the bolt (12) are in each case manufactured in an injection mould in order to keep the scatter of the functional dimensions for the locking and unlocking small.

9. Module carrier comprising a plug module in accordance with any one of the claims 1 to 8, **characterised in that** the space requirement for the lever (6) and the bolt (12) lies within the dimensions of the IEEE STANDARD 1101.10 which are allowed for the insertion and removal handle (5).

10. Module carrier comprising a plug module in accordance with any one of the claims 1 to 9, **characterised in that** the lever arm (6) is aligned parallel to the front plate (35) of the plug module in the rear end position (10) of the plug module (2) in order to stand off as little as possible from the front plate in normal operation.

11. Module carrier comprising a plug module in accordance with any one of the claims 1 to 10, **characterised in that** the bolt (12) actuates a switch element (11) for an active switching of the plug module (2) after reaching an effective latched position and also that, on depressing the bolt (12), this brings about a passive switching at the switch element before the lever (6) is released by the bolt.

12. Module carrier in accordance with claim 11, **characterised in that** the bolt (12) has a cam (23) for the actuation of the switch element (11) which is displaceable transverse to the switching direction of the switch element (11).

13. Module carrier with a plug module in accordance with one of the claims 11 or 12, **characterised in that** the electrical switch element (11) is a microswitch.

14. Module carrier with a plug module in accordance with one of the claims 11 to 13, **characterised in that** a status display (37) for the passive switching of the plug module is provided behind the locked lever (6); and **in that** the lever has a window (15a) or is transparent in order that the status display (37) can be read off from the front.

## Revendications

1. Support d'unité avec une unité enfichable (2), qui est insérable au moyen de guidages (3) dans un boîtier (4) et qui est pourvue d'au moins une prise d'insertion et de dégagement (5) sous la forme d'un levier (6), logé sur un axe (16), à son côté frontal (7), pour surmonter par l'appui à un profil de boîtier côté avant (8) des forces de poussée et d'extraction à des prises multiples disposées au côté arrière, **caractérisé en ce qu'**il est disposé pour la prise d'insertion et de dégagement (5) un verrou additionnel (12) actionné par ressort au côté frontal (7) qui verrouille le levier nécessairement dans une position d'extrémité arrière (10) de l'unité enfichable et qui, après le déverrouillage du levier (6), rend un verrouillage du levier seulement possible lorsque le levier (6) a été tourné au moins selon un angle α ≥ ε dans la direction de sortie et de nouveau en arrière dans la position d'extrémité finale (10), où l'angle ε représente un recouvrement au moyen duquel le verrou (12) se bloque lui-même dans la position de déverrouillage (14) à une face de guidage (21) du levier (6), tandis que lors de la rotation du levier (6) selon un angle α ≥ ε et retour, le verrou (12) est retenu par la face de guidage (21) dans une autre position de déverrouillage (13).

2. Support d'unité avec une unité enfichable selon la revendication 1, **caractérisé en ce que** le déverrouillage est stocké primairement par un élément de ressort (22) fixé au verrou (12) qui, lors de l'enfoncement du verrou (12) le long d'un épaulement incliné (18) du levier (6), peut être dévié selon l'angle ε contre la direction d'expulsion du levier pour, après avoir quitté l'épaulement incliné (18), rebondir dans une position avec un chevauchement de la grandeur de l'angle ε.

3. Support d'unité avec une unité enfichable selon la revendication 2, **caractérisé en ce qu'**il est prévu comme élément de ressort (22) un ressort à lames (17) et **en ce que** le ressort à lames (17) et le verrou (12) présentent des faces d'engagement (19, 20) qui sont applicables à une face de guidage (21) du levier (6) apte à pivoter autour de l'axe (16), où la face d'engagement (19) de l'élément de ressort (22) est éloignée d'une hauteur h plus loin de l'axe (16) que la face d'engagement (20) du verrou (12).

4. Support d'unité avec une unité enfichable selon l'une des revendications 1 à 3, **caractérisé en ce que** le verrou (12), contrairement à sa direction de poussée vers le bas, est pourvu d'un ressort de rappel (24) s'appuyant d'une manière fixe.

5. Support d'unité avec une unité enfichable selon l'une des revendications 1 à 4, **caractérisé en ce que** l'unité enfichable (2) présente un autre mécanisme de verrouillage, identique du point de vue mécanique, pour pouvoir renoncer à des éléments d'assurance mécaniques additionnels, comme par exemple des vis de fixation.

6. Support d'unité avec une unité enfichable selon la revendication 5, **caractérisé en ce que** sont disposés au côté frontal de l'unité enfichable des tiges de centrage (25) faisant saillie dans la direction d'insertion, qui orientent l'unité enfichable (2) au côté frontal dans des perçages adaptés (26) au profil de boîtier (8) côté frontal.

7. Support d'unité avec une unité enfichable selon l'une des revendications 1 à 6, **caractérisé en ce que** l'angle de chevauchement ε est plus petit que l'angle ϕ pour le changement de flanc au levier de prise (6) entre la fin de la poussée dans la position d'extrémité arrière (10) et le début de la sortie par poussée de l'unité enfichable (2) en sens inverse.

8. Support d'unité avec une unité enfichable selon l'une des revendications 1 à 7, **caractérisé en ce que** le levier (6) et le verrou (12) sont fabriqués à chaque fois dans un moule pour maintenir la dispersion de la masse fonctionnelle pour le verrouillage et le déverrouillage à un niveau réduit.

9. Support d'unité avec une unité enfichable selon l'une des revendications 1 à 8, **caractérisé en ce que** la place requise pour le levier (6) et le verrou (12) se situe à l'intérieur des dimensions IEEE STANDARDS 1101.10 autorisées pour la prise d'insertion et de dégagement (5).

10. Support d'unité avec une unité enfichable selon l'une des revendications 1 à 9, **caractérisé en ce que** le bras de levier (6), dans la position d'extrémité arrière (10) de l'unité enfichable (2) est orienté parallèlement à la plaque frontale (35) de l'unité enfichable pour faire saillie en fonctionnement normal le moins possible de la plaque frontale.

11. Support d'unité avec une unité enfichable selon l'une des revendications 1 à 10, **caractérisé en ce que** le verrou (12), après l'atteinte d'une position de verrouillage efficace, actionne un élément de commutation (11) pour une commutation d'activation de l'unité enfichable (2), et que lors d'un enfoncement du verrou (12), celui-ci provoque à l'élément de commutation (11) une commutation de désactivation avant que le levier (6) ne soit libéré par le verrou.

12. Support d'unité avec une unité enfichable selon la revendication 11, **caractérisé en ce que** le verrou (12) présente une came (23) pour actionner l'élément de commutation (11), qui est déplaçable transversalement à la direction de commutation de l'élément de commutation (11).

13. Support d'unité avec une unité enfichable selon l'une des revendications 11 ou 12, **caractérisé en ce que** l'élément de commutation électrique (11) est un micro-commutateur électrique.

14. Support d'unité avec une unité enfichable selon l'une des revendications 11 à 13, **caractérisé en ce qu'**il est disposé derrière le levier verrouillé (6) une indication de statut(37) de la commutation de désactivation de l'unité enfichable, et **en ce que** le levier présente une fenêtre (15a) ou est transparent pour que l'indication du statut (37) soit lisible de devant.
